# EUROPEAN PATENT APPLICATION

(11) **EP 4 276 889 A1**
(43) Date of publication of application: **15.11.2023**
(21) Application number: 23172009.5
(22) Date of filing: 08.05.2023
(51) Int. Cl.: H01L 21/60, H01L 23/492, H01L 23/495

(54) **METHOD OF MANUFACTURING A SEMICONDUCTOR DEVICE AND THE CORRESPONDING SEMICONDUCTOR DEVICE**

(30) Priority: 12.05.2022 IT 202200009839
(71) Applicant: STMicroelectronics S.r.l., 20864 Agrate Brianza (MB) (IT)
(72) Inventor: GOTTARDI, Thomas, 20835 Muggiò (Monza Brianza) (IT); MODARELLI, Nicoletta, 20132 Milano (IT); CATALANO, Guendalina, 20125 Milano (IT)
(74) Representative: Bosotti, Luciano

(57) **Abstract**

A semiconductor die (14) is attached on a die-attachment portion (12A) of a planar substrate (12) and a planar electrically conductive clip (16) in mounted onto the semiconductor die (14). The electrically conductive clip (16) has a distal portion (16A) extending away from the semiconductor die (14) with the semiconductor die (14) sandwiched between the substrate (12) and the at least one electrically conductive clip (16). The substrate (12) includes electrically conductive leads (12B) arranged facing the distal portion (16A) of the electrically conductive clip (16) with a gap (G) formed therebetween.

The gap (G) is filled with a mass of gap-filling material (20) transferred to the gap (G) via Laser Induced Forward Transfer, LIFT processing, the mass (20) sized and dimensioned to fill the gap (G).

## Description

### Technical field

The description relates to manufacturing semiconductor devices.

The description refers, by way of example, to manufacturing dual-side cooling packages for semiconductor devices.

### Background

A dual-side cooling packages for semiconductor power devices currently comprises a leadframe as substrate and one or more semiconductor chips or dice sandwiched between the substrate and one or more flat clips.

The assembly thus created includes a gap due to the die thickness (70 microns, for instance) formed between mutually facing (distal) portions of the substrate and the clip(s).

Such a gap could be attempted to be accommodated by machining the clip material (via milling or extrusion, for example) which may be expensive.

Another approach may involve clip tip bending; this is hardly practicable due to clip thickness (more than 600 microns).

Still another approach may involve using leadframes with dual lead levels or leadframes produced in two different parts that are subsequently connected: this is again fairly expensive. In any case, dedicated leadframes and/or clips may reduce the time-to-market and increase the final cost a product.

Mounting a stand-off/spacer (a thin copper foil, for instance) using solder paste or glue can also be considered. Such an approach is difficult to implement since the resulting assembly is exposed to a (first) oven reflow for die attachment before clip mounting. The temperature increase resulting from reflow tends to cause undesired spacer bending/lift-off.

Document JP 2020 013955 A discloses a semiconductor device including: a semiconductor chip formed with a semiconductor element for electric power having a first electrode and a second electrode; a resistive element; a sealing body sealing the semiconductor chip and the resistive element; a first external terminal connected with the first electrode; and a second external terminal connected with the second electrode through the resistive element. A low-resistance material such as manganin can be used as the resistance material.

Document JP 2019 186321 A discloses a semiconductor device including a semiconductor element 11 in which a first electrode (gate electrode) and a second electrode (source electrode) are formed, multiple leads each conducting with the semiconductor element, and an encapsulation resin having a first resin side surface and a second resin side surface directing the opposite sides from each other in the y direction orthogonal to the z direction, and covering a part of the multiple leads and the semiconductor element. The multiple leads include first leads conducting with the first electrode and a second lead conducting with the second electrode. The first leads include a first mounting part (first terminal part) exposed from the first resin side surface, and the second lead includes a second mounting part (second terminal part) exposed from the first resin side surface. The second mounting part is juxtaposed to the first mounting part in the x direction, and has the dimension in the x direction larger than that of the first mounting part. In JP 2019 186321 A leads are shown that are not flat and flush with the die and a gap is provided filled with a single material (such as solder or Ag paste).

Document US 2015/294951 A1 generally discloses a method for assembly of a micro-electronic component comprising the steps of: providing a conductive die bonding material comprising of a conductive thermosettable resin material or flux based solder and a dynamic release layer adjacent to the conductive thermoplastic material die bonding material layer; and impinging a laser beam on the dynamic release layer adjacent to the die bonding material layer; in such a way that the dynamic release layer is activated to direct conductive die bonding material matter towards the pad structure to be treated to cover a selected part of the pad structure with a transferred conductive die bonding material; and wherein the laser beam is restricted in timing and energy, in such a way that the die bonding material matter remains thermosetting. Accordingly adhesive matter can be transferred while preventing that the adhesive is rendered ineffective by thermal overexposure in the transferring process.

### Object and summary

Solutions as described herein aim at addressing the issues discussed in the foregoing.

Such an object can be achieved via a method having the features set forth in the claims that follow.

One or more embodiments also relate to a corresponding semiconductor device.

The claims are an integral part of the technical teaching provided herein in respect of the embodiments.

In solutions as described herein, a spacer (e.g., copper) is formed via Laser Induced Forward Transfer, LIFT processing on the lead side to compensate for die thickness.

LIFT processing can accommodate a high die thickness in a direct-write approach, for instance.

The related process can be easily tuned to different die thicknesses without having to manage different clip or leadframe references.

LIFT processing has been found to be largely advantageous over other "printing" processes within the context of use considered herein.

Solutions as presented herein offer one or more of the following advantages:
adaptability ("customization") to different types of power packages,
applicability to leadframes and clips having a single thickness ("mono-thickness"),
cost savings (only a leadframe preparation step may be added),
capability of covering a variety of products/packages with a simple, single assembly step with no appreciable effect on the rest of the assembly flow.

### Brief description of the several views of the drawings

One or more embodiments will now be described, by way of example only, with reference to the annexted figures, wherein:
Figure 1 is a cross-sectional view of a semiconductor power device suited to be manufactured with embodiments of the present description,
Figures 2A, 2B and 2C are exemplary of steps in a Laser Induced Forward Transfer, LIFT process, and
Figures 3A to 3F are exemplary of possible steps in implementing embodiments of the present description.

Corresponding numerals and symbols in the different figures generally refer to corresponding parts unless otherwise indicated.

The figures are drawn to clearly illustrate the relevant aspects of the embodiments and are not necessarily drawn to scale.

The edges of features drawn in the figures do not necessarily indicate the termination of the extent of the feature.

### Detailed description

In the ensuing description one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in one or more points of the present description do not necessarily refer to one and the same embodiment.

Moreover, particular conformations, structures, or characteristics may be combined in any adequate way in one or more embodiments.

The headings/references used herein are provided merely for convenience and hence do not define the extent of protection or the scope of the embodiments.

For simplicity and ease of explanation, throughout this description:
like parts or elements are indicated in the various figures with like reference signs, and a corresponding description will not be repeated for each and every figure, and
manufacturing a single device will be described, being otherwise understood that current manufacturing processes of semiconductor devices involve manufacturing concurrently plural devices that are separated into single individual devices in a final singulation step.

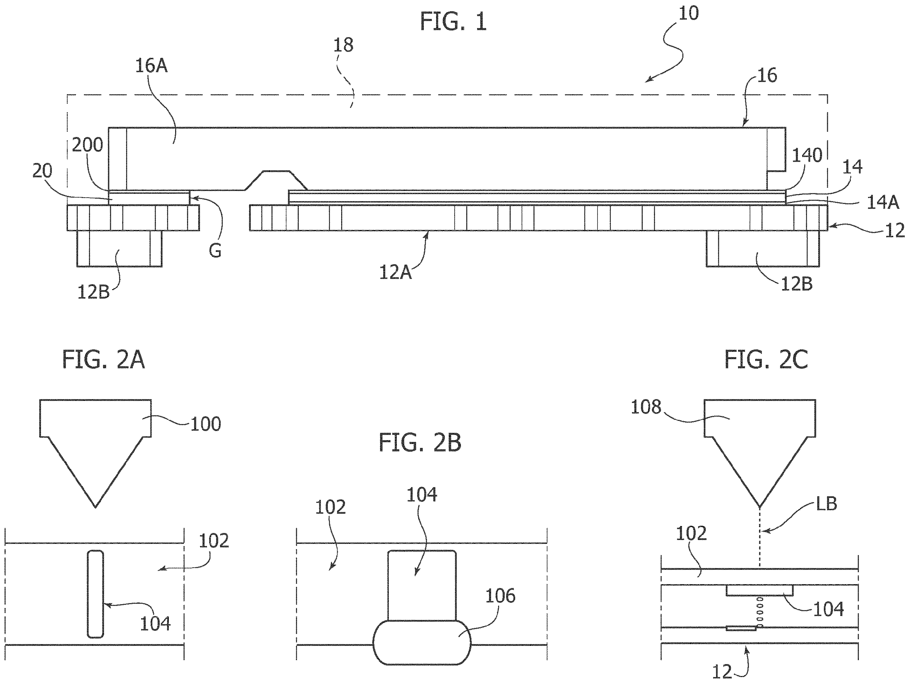

Figure 1 is a cross-sectional view through a semiconductor (power) device 10 that comprises - in a manner known per se to those of skill in the art:
a metal substrate (leadframe) 12 in turn comprising a die-mounting area (die pad) onto which one or more semiconductor chips or dice 14 are mounted via a solder paste layer (not visible due to scale reasons), and
one or more clips 16 in turn arranged onto the chip or chips 14 to provide a electrical connection of the chip or chips 14 to a set of electrically conductive "distal" leads 12B (on the left-hand side of the figure) of the leadframe 12.

Other leads 12B associated with the die-mounting portion 12A of the leadframe 12 are visible on the righthand side of Figure 1.

The designation "leadframe" (or "lead frame") is currently used (see, for instance the USPC Consolidated Glossary of the United States Patent and Trademark Office) to indicate a metal frame that provides support for an integrated circuit chip or die as well as electrical leads to interconnect the integrated circuit in the chip or die to other electrical components or contacts.

Essentially, a leadframe comprises an array of electrically conductive formations (or leads, e.g., 12B) that from an outline location extend inwardly in the direction of a semiconductor chip or die (e.g., 14) thus forming an array of electrically conductive formations from a die pad (e.g., 12A) configured to have - at least one - semiconductor chip or die attached thereon.

For the sake of simplicity, a single chip or die 14 and a single clip 16 will be referred to throughout this description, being otherwise understood that solutions as discussed herein also apply to to arrangements including plural semiconductor chips or dice 14 and/or plural clips 16.

An encapsulation of insulating material 18 (an epoxy resin, for instance: the outline of the material 18 is illustrated in dashed lines in Figure 1) is molded onto the assembly thus described, leaving the leads 12B accessible. A case is thus provided that surrounds the semiconductor material to protect it from corrosion or physical damage while facilitating mounting the device onto a mounting substrate such as a Printed Circuit Board, PCB, not visible in the figures).

Observation of Figure 1 shows that, due to dice thickness, a gap G is formed between the "distal" end of the clip 14 and the leads 12B arranged facing that distal end of the clip 16.

As illustrated herein, the gap G is related to the fact that the substrate 12 is planar and the electrically conductive clip 16 is likewise planar (flat, as discussed previously). It is otherwise noted that (as visible in Figure 1) such planar/flat clips may exhibit some sort of sculpturing or topography while not derogating from the two-dimensional quality underlying the definition of "planar" (see, e.g., www.merriam-webster.com/dictionary/flat).

Just by way of reference (and with no limitative intent) the leadframe 12B may have a thickness of 500 microns and the die 14 may in turn have a thickness of 70 micron, to which the thicknesses of the die attach material used to attach the die 14 onto the leadframe 12.

Consequently, the gap G may have a thickness (width in the vertical direction of Figure 1) of about 70 + 25 microns. This quantitative figure is of course merely exemplary and not limiting of the embodiments.

As discussed, a gap as indicated by G could be attempted to be compensated (bridged) by resorting to different approaches (clip material milling/extrusion, clip bending, leadframes with dual lead levels or including two different elements connected).

These approaches exhibit various types of disadvantages.

For instance, in the case of clip material milling, a fairly large amounts of clip materials may have to be removed, possibly respecting fairly tight tolerances in terms of thickness and planarity. Additionally, this may be a fairly expensive solution.

Clip bending may involve risks of cracking (the die or dice 14) due to the thickness of the clip material 16( e.g., 650 microns).

Resorting to leadframes with dual lead levels or including separate elements is generally expensive and may involve additional assembly steps.

Solutions as discussed herein address the problem of compensating (filling or bridging) a gap such as that the gap G, growing electrically conductive material resorting to Laser-Induced Forward Transfer, LIFT technology.

The acronym LIFT denotes a deposition process where material from a donor tape or sheet is transferred to an acceptor substrate facilitated by laser pulses.

General information on the LIFT process can be found, for instance, in P. Serra, et al.: "Laser-Induced Forward Transfer: Fundamentals and Applications", in Advanced Materials Technologies/Volume 4, Issue 1.

Essentially, solutions as discussed herein contemplate (filling or bridging) the gap G via a mass 20 of electrically conductive material transferred via LIFT processing onto the leads 12A facing the distal end of the clip 16.

It is noted that, in comparison with other "printing" processes that could be notionally envisaged to fill the gap G, LIFT processing facilitates providing a "customized" connection between the back or bottom side of the clip 16 and the leads 12A in leadframe 12.

Advantageously, LIFT processing facilitates adapting the thickness of the material transferred via LIFT processing (typically in subsequent layers) to the width of the gap G by adapting precisely to possible variations thereof, e.g., variations in die thickness for various dice in a batch.

Figures 2A, 2B and 2C are exemplary of possible implementations of LIFT processing that are advantageously adapted for use in a context as considered herein.

In Figure 2A, reference 100 indicates a paste dispenser head configured to deposit on a donor film 102 an electrically conductive paste 104 (an Ag/Cu paste, for instance).

Figure 2B is exemplary of the possibility of spreading the paste 104 to a desired width (and thickness) via a laminator 106 (essentially a doctor blade).

As exemplified in Figure 2C, a laser beam LB from a laser source 108 can then be used to transfer the paste 104 from the donor film 102 onto a substrate such as, for instance, the leadframe 12 (at the leads 12B located at the gap G).

Essentially, the action of the laser source 108 (a UV laser, for instance) is to "shoot" a laser beam LB onto the back side of the donor tape 102, so that the paste 104 spread on the front side of the donor tape 102 is projected and dispensed (in an ultra-fast mode) onto the substrate 12 to provide - in one or more steps - the "gap-bridging" material 20.

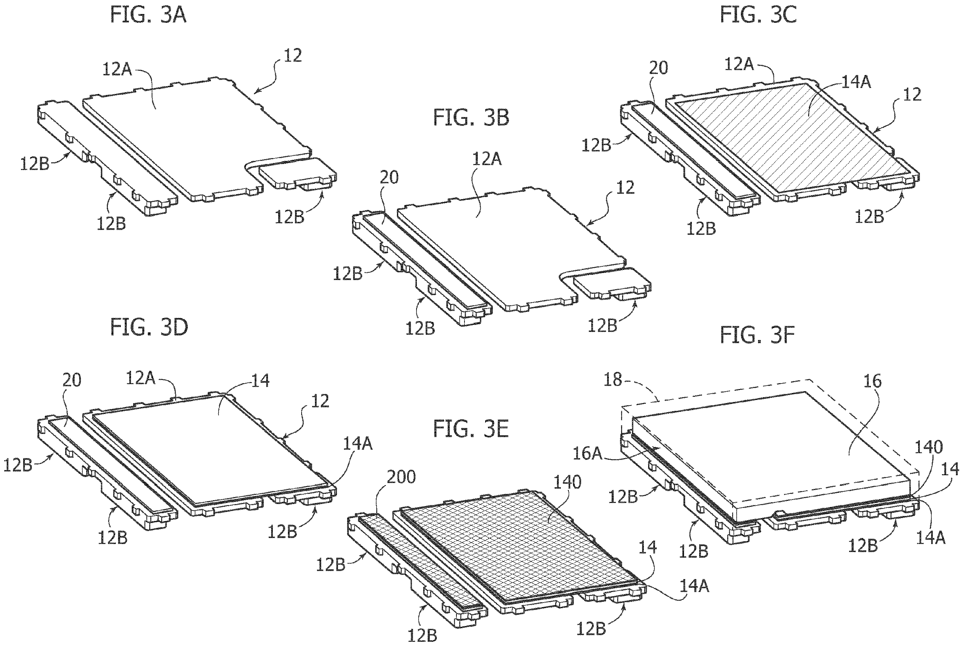

Figures 3A to 3F are illustrative of a possible sequence of steps in implementing a solution as discussed herein.

It will be otherwise appreciated that the sequence of steps of Figures 3A to 3F is merely exemplary insofar as:
one or more steps illustrated in Figures 3A to 3F can be omitted, performed in a different manner (with other tools, for instance) and/or replaced by other steps;
additional steps may be added;
one or more steps can be carried out in a sequence different from the sequence illustrated.

Figure 3A is exemplary of the provision of a leadframe 12, including a die-mounting portion (die pad) 12A and electrically conductive leads, including "distal" leads (on the left-hand side of the figure) where a gap G may be formed for the reasons discussed in the foregoing.

Figure 3B is exemplary of the deposition (via LIFT processing) onto the "distal" leads 12B of the leadframe 12 of one or more layers of material (copper, for instance) up to a resulting thickness corresponding to the thickness of the gap G to be bridged.

This thickness is known beforehand since the thickness of the die 14 (and the die attach material of the die 14 onto the die pad 12A of the leadframe 12) are known as process parameters. It will be otherwise noted that solutions as discussed herein may adapt to different thicknesses of the die 14 (and the die attach material) in a very flexible way.

Figure 3C is exemplary of the deposition of such die attach layer 14A (of a solder paste, for instance) to facilitate die attachment as illustrated in Figure 3D.

As noted, steps illustrated in Figures 3A to 3F can be carried out in a sequence different from the sequence illustrated.

For instance, LIFT deposition of the material 20 onto the "distal" leads 12B of the leadframe 12 can be:
prior to mounting the chip 14 on the leadframe 12, that is, prior to forming the gap G, or
after mounting the chip 14 on the leadframe 12, possibly after forming the gap G, or
concurrent with mounting the chip 14 on the leadframe 12.

Irrespective of which specific option is adopted for depositing the gap-filling material, deposition of the material 20 (copper, for instance) via LIFT processing may be in one or more layers up to a resulting thickness corresponding to the thickness of the gap G to be bridged.

Irrespective of which specific option is adopted for depositing the gap-filling material 20 (after, before or during forming the gap G), the gap G is eventually filled (bridged) with a mass of gap-filling material 20 in the gap G.

Solutions as discussed herein may adapt to different thicknesses of the die 14 (and the die attach material) in a very flexible way so that, as visible in the final product (finished device), the mass of gap-filling material 20 in the gap G, is sized and dimensioned to fill (that is, to bridge) the gap G.

Figure 3E is exemplary of material such as solder paste being dispensed onto the chip 14 (solder paste 140) and onto the LIFT deposited layer or layers 20 (paste material 200) in order to facilitate attaching the clip or clips 16, as exemplified in Figure 3F.

It is noted that the solder paste layers 140 and 200 may have a same thickness and thus may not play a major role in compensating the gap G.

As exemplified in dashed lines in Figure 3F an insulating encapsulation 18 can then be formed on the resulting assembly as otherwise conventional in the art.

Without prejudice to the underlying principles, the details and embodiments may vary, even significantly, with respect to what has been described by way of example only without departing from the extent of protection.

The extent of protection is determined by the annexed claims.

## Claims

1. A method, comprising:
attaching at least one semiconductor die (14) on a die-attachment portion (12A) of a substrate (12),
mounting onto the at least one semiconductor die (14), at least one electrically conductive clip (16) wherein the at least one semiconductor die (14) is sandwiched between the substrate (12) and the at least one electrically conductive clip (16), wherein the at least one electrically conductive clip (16) has a distal portion (16A) extending away from the at least one semiconductor die (14) and the substrate (12) includes electrically conductive leads (12B) arranged facing the distal portion (16A) of the at least one electrically conductive clip (16) with a gap (G) formed therebetween,
filling the gap (G) with a mass of gap-filling material (20) transferred via Laser Induced Forward Transfer, LIFT processing.

2. The method of claim 1 wherein the gap-filling material (20) comprises copper or silver.

3. The method of claim 1 or claim 2, comprising transferring the mass of gap-filling material (20) in a plurality of LIFT processing steps.

4. The method of any of the previous claims, comprising filling the gap (G) via a mass of gap-filling material (20) transferred via LIFT processing onto said electrically conductive leads (12B) arranged facing the distal portion (16A) of the at least one electrically conductive clip (16).

5. The method of any of the previous claims, comprising dispensing masses of attachment material (140, 200) onto the at least one semiconductor die (14) attached on the die-attachment portion (12A) of the substrate (12) as well as onto the mass of gap-filling material (20) transferred to the gap (G) via Laser Induced Forward Transfer, LIFT processing.

6. A device (10), comprising:
at least one semiconductor die (14) attached on a die-attachment portion (12A) of a substrate (12),
at least one electrically conductive clip (16) mounted onto the at least one semiconductor die (14), wherein the at least one semiconductor die (14) is sandwiched between the substrate (12) and the at least one electrically conductive clip (16), wherein the at least one electrically conductive clip (16) has a distal portion (16A) extending away from the at least one semiconductor die (14) and the substrate (12) includes electrically conductive leads (12B) arranged facing the distal portion (16A) of the at least one electrically conductive clip (16) with a gap (G) therebetween, and
a mass of gap-filling material (20) in the gap (G) is sized and dimensioned to fill said gap (G).

7. The device (10) of claim 6, wherein the substrate (12) and the at least one electrically conductive clip (16) are planar.

8. The device (10) of claim 6 or claim 7, wherein the gap-filling material (20) comprises copper or silver.

9. The device (10) of any of claims 6 to 8, comprising masses of attachment material (140, 200) dispensed onto the at least one semiconductor die (14) attached on the die-attachment portion (12A) of the substrate (12) as well as onto the mass of gap-filling material (20) in said gap (G).
